# EUROPÄISCHE PATENTSCHRIFT

(11) **EP 0 797 120 B1**
(45) Veröffentlichungstag und Bekanntmachung des Hinweises auf die Patenterteilung: **16.08.2000**
(21) Anmeldenummer: 97104113.2
(22) Anmeldetag: 12.03.1997
(51) Int. Cl.: G03F 7/095, G03F 1/00

(54) **Zur Herstellung von Flexodruckplatten durch digitale Informationsübertragung geeignetes mehrschichtiges Aufzeichnungselement**
Multilayer recording element suitable for the production of flexographic printing plates by digital information transmission
Elément pour l'enregistrement multicouche utilisable pour la production des plaques d'impression flexographiques par transmission d'information digitale

(30) Priorität: 22.03.1996 DE 19611262
(43) Veröffentlichungstag der Anmeldung: 24.09.1997
(73) Patentinhaber: BASF Coatings Aktiengesellschaft, 48165 Münster (DE)
(72) Erfinder: Loerzer, Thomas, Dr., 76829 Landau (DE); Scherer, Cliff, 80634 München (DE); Nuyken, Oskar, Prof.-Dr., 81927 München (DE)
(74) Vertreter: Karg, Jochen

(56) Entgegenhaltungen:
- EP-A- 0 369 398
- EP-A- 0 634 695
- EP-A- 0 767 407
- WO-A-94/03839
- PATENT ABSTRACTS OF JAPAN vol. 7, no. 138 (P-204), 10.Juni 1983 & JP 58 052646 A (DAINIPPON INSATSU KK), 28.März 1983,

## Beschreibung

Die Erfindung betrifft ein zur Herstellung von Flexodruckplatten durch digitale Informationsübertragung geeignetes mehrschichtiges Aufzeichnungselement, das auf einem dimensionsstabilen Träger übereinander angeordnet eine, gegebenenfalls mit dem dimensionsstabilen Träger durch eine Haftschicht verbundene, durch aktinische Strahlung vernetzbare Schicht, eine durch aktinische Laserstrahlung ablatierbare Schicht sowie gegebenenfalls eine abziehbare Deckfolie aufweist.

Flexographische Druckformen bestehen aus einer lichtempfindlichen photopolymerisierbaren Schicht, die auf einem dimensionsstabilen Träger, wie z.B. einer Polyethylenterephthalatfolie oder auch einem Aluminiumblech, aufgebracht ist. Zwischen diesen Schichten kann noch eine Adhäsionsschicht appliziert sein, um den Verbund haftfest auszurüsten. Auf der lichtempfindlichen, photopolymerisierbaren Schicht kann sich außerdem noch eine Deckschicht befinden. Diese Deckschicht wird immer dann benötigt, wenn die darunterliegende lichtempfindliche, photopolymerisierbare Schicht so klebrig ist, daß beim Auflegen des photographischen Negativs die vorhandene Luft im Vakuumbelichtungsrahmen nicht gleichmäßig entfernt werden kann, was dann sogenannte Vakuumfehler beim Belichten zur Folge hätte.

Auf diese lichtempfindlichen, photopolymerisierbaren Schichten werden durch Auflegen eines photographischen Negativs, Entfernen der Luft mittels Vakuumrahmen und vollflächiges Belichten die im photographischen Negativ enthaltenen Informationen übertragen. Im anschließenden Entwicklungsschritt werden die nichtphotopolymerisierten Bereiche durch geeignete Entwickler entfernt; die photopolymerisierten Bildteile sind nicht löslich und bilden so die Reliefstruktur. Der Entwickler muß auf die verwendete photopolymerisierbare Schicht und gegebenenfalls auch auf die verwendete Deckschicht abgestimmt sein. Als geeignete Entwickler werden je nach Art des Bindemittels im allgemeinen Gemische aus Perchlorethylen mit Alkoholen, Gemische aus Kohlenwasserstoffen mit Alkoholen, Gemische aus Alkohol und Wasser, reines Wasser oder auch Gemische aus Wasser und darin löslichen Bestandteilen, wie z.B. Soda, Natronlauge, Zitronenlauge, Milchsäure, Tenside usw. benutzt. Dem Entwicklungsschritt schließt sich ein Trocknungsschritt an, um den Entwickler aus der angequollenen Reliefschicht zu entfernen. Je nach lichtempfindlichem Material kann die Platte noch weitere Verarbeitungsschritte benötigen. So ist bei manchen Druckformen noch eine vollflächige Nachbelichtung erforderlich, um die Druckform vollständig auszuhärten. Auch können z.B. bei Druckformen auf Basis von Styrol-Butadien (Isopren)-Blockcopolymeren die Oberflächen durch eine UVC-Nachbehandlung entklebt werden.

Bei dem hier geschilderten Verfahren wird die Information über ein photographisches Negativ übertragen. Nach dem Stand der Technik können photographische Negative durch Belichtung eines lichtempfindlichen Films mittels eines Plotters mit nachfolgender Entwicklung hergestellt werden. Die Information, die dabei auf den Film übertragen wird, entstammt heutzutage einem digitalisierten Datenbestand. Von daher wäre es wünschenswert, wenn eine Flexodruckform ohne den Umweg über ein photographisches Negativ hergestellt werden kann. Neben verkürzten Herstellzeiten würden die Kosten für die Herstellung eines photographischen Negativs entfallen. Außerdem würden die naßchemischen Prozesse bei der Filmentwicklung nicht mehr benötigt werden. Zudem können sich die geometrischen Maße eines photographischen Negativs durch Temperatur und Luftfeuchtigkeit ändern, was zu Registerproblemen der fertigen Flexodruckform führen kann, da beim Belichten einer entsprechenden lichtempfindlichen photopolymerisierbaren Schicht die Information des photographischen Negativs projizierend 1:1 übertragen wird.

Digitale Verfahren, bei denen kein photographisches Negativ benötigt wird, sind ebenfalls schon seit langem bekannt.

So wird in der US-A-4555471 ein Maskenfilm beschrieben, der direkt auf einer photopolymerisierbaren Platte aufgebracht sein kann. Durch eine Laserbelichtung läßt sich der Maskenfilm, der ein thermochromes System besitzt, in der optischen Dichte beeinflussen, und man kann auf diese Weise das Negativ erzeugen.

Auch in der EP 0001138-A 1 wird ein Verfahren zur Herstellung von lithographischen Druckplatten unter Bildung eines "fugitive negative" beschrieben.

In der DE 4117127 A 1 wird ein Verfahren beschrieben, bei dem eine Bildmaske auf lichtempfindlichen Aufzeichnungselementen durch Nutzung eines Tintenstrahldruckers oder eines elektrophotographischen Druckers, erzeugt wird. Nachteil ist hier, daß die Auflösung für den Hochqualitätsflexorasterdruck nicht ausreichend fein genug ist.

In der WO 94/03839 wird ein Verfahren beschrieben, bei dem mittels eines IR-Lasers ein lichtempfindliches Aufzeichnungselement strukturiert wird und auf diese Weise eine Bildmaske erzeugt wird. Das lichtempfindliche Aufzeichnungselement besteht hier aus einem Träger, einer lichtempfindlichen Schicht, einer IR-lichtempfindlichen Schicht, die für aktinisches Licht undurchlässig ist, und einer Folie. Bei der Belichtung mit dem IR-Laser werden die belichteten Stellen der IR-lichtempfindlichen Schicht an die darüberliegende Folie fixiert und können durch Abziehen der Folie mitentfernt werden. Man erhält so eine Bildmaske auf der lichtempfindlichen Aufzeichnungsschicht. Nachteilig ist hier, daß Beschädigungen, wie z.B. Kratzer, der Folie, die auch als mechanischer Schutz wirken soll, zu einer fehlerhaften Informationsübertragung führt.

In der US-A-5262275 wird ein Verfahren beschrieben, bei dem auch mittels IR-Laser Flexodruckformen digital bebildert werden. Das Aufzeichnungselement besteht aus einem Träger, einer lichtempfindlichen Schicht, einer Sperrschicht und einer IR-lichtempfindlichen Schicht, die für aktinisches Licht undurchlässig ist. Die IR-lichtempfindliche Schicht wird direkt mit dem IR-Laser beschrieben, wobei an den beschriebenen Stellen das IR-lichtempfindliche Material verdampft wird und damit an diesen Stellen für aktinisches Licht durchlässig wird. Die noch vorhandene Sperrschicht verbleibt auf der Oberfläche der photopolymerisierbaren Schicht.

Diese Sperrschicht soll verhindern, daß atmosphärischer Sauerstoff während der Photopolymerisation in die photopolymerisierbare Schicht eindringt und somit die Belichtungszeit erhöht. Weiterhin sollen auch die Ergebnisse des Belichtungsschrittes im Vergleich zu einem Aufzeichnungselement, bei dem diese Sperrschicht fehlt, besser reproduzierbar sein.

In der DE-19536805-A wird ebenfalls ein Verfahren zur Herstellung von Flexodruckformen beschrieben, bei dem auf die Sperrschicht verzichtet werden kann und die erhaltene Druckform überraschenderweise sehr viel bessere Druckergebnisse zeigt.

Aufgabe der vorliegenden Erfindung ist es, eine zur Herstellung von Flexodruckplatten durch digitale Informationsübertragung geeignetes mehrschichtiges Aufzeichnungselement aufzuzeigen, bei dem anstelle des teuren IR-Lasers ein kostengünstiger UV-Laser benutzt wird, um eine Maske zu erzeugen. Überraschenderweise läßt sich dies durch den erfindungsgemäßen Schichtaufbau erreichen.

Gegenstand der vorliegenden Erfindung sind zur Herstellung von Flexodruckplatten durch digitale Informationsübertragung geeignete mehrschichtige Aufzeichnungselemente, die auf einem dimensionsstabilen Träger übereinander angeordnet eine, gegebenenfalls mit dem dimensionsstabilen Träger durch eine Haftschicht verbundene, durch aktinische Strahlung vernetzbare Schicht (A), eine ebenfalls gegen aktinische Strahlung empfindliche Schicht (B) sowie gegebenenfalls eine abziehbare Deckfolie aufweisen und dadurch gekennzeichnet sind, daß die durch aktinische Strahlung vernetzbare Schicht (A) durch bildmäßige Belichtung mit aktinischer Strahlung von 0,5 bis 5 J/cm² vernetzt wird und danach durch Entwickler auswaschbar ist und im wesentlichen aus einem Gemisch aus mindestens einem elastomeren Bindemittel, ethylenisch ungesättigten copolymerisierbaren organischen Verbindungen, einem Photoinitiator oder Photoinitiatorsystem sowie gegebenenfalls weiteren Hilfsstoffen besteht, und die auch gegen aktinische Strahlung empfindliche Schicht (B) eine in Entwickler lösliche oder dispergierbare Schicht ist, die im aktinischen Bereich eine optische Dichte > 2,5 aufweist, durch einen oder mehrere Laserpulse im Wellenlängenbereich zwischen 254 und 532 nm mit einer Energie von > 5 bis zu 50 J/cm² eine Änderung der optischen Dichte von > 1 erfährt und im wesentlichen aus arylazophosphonathaltigen Verbindungen besteht.

Zu den vorteilhaften Ausgestaltungsmöglichkeiten der erfindungsgemäßen Aufzeichnungselementen gehört, daß sowohl für die Schicht (A) als auch für die Schicht (B) Wasser oder Alkohol/Wasser-Gemische als Entwickler geeignet sind, bzw. daß sowohl für Schicht (A) als auch für Schicht (B) ein organisches Lösungsmittel oder Lösungsmittelgemisch geeignet ist, oder auch für Schicht (A) ein organisches Lösungsmittel oder Lösungsmittelgemisch und für Schicht (B) Wasser oder ein Alkohol/Wasser-Gemisch als Entwickler geeignet ist.

Gegenstand der vorliegenden Erfindung ist auch ein Verfahren zur Herstellung von Flexodruckplatten, das dadurch gekennzeichnet ist, daß mit einem UV-Laser die gegen aktinische Strahlung empfindliche Schicht (B) des mehrschichtigen Aufzeichnungselementes aus einem digitalen Datenbestand bildmäßig strukturiert wird und so eine Maske auf der darunterliegenden Schicht (A) erzeugt wird, anschließend die Schicht (A) durch vollflächige Belichtung mit aktinischer Strahlung in den später druckenden Bereichen vernetzt wird, und danach die Schicht (B) in einem Entwickler dispergiert oder gelöst wird und in demselben oder einem anderen Entwickler die nicht vernetzten Bildteile der Schicht (A) entwickelt werden.

Das erfindungsgemäße Aufzeichnungselement ist hervorragend für die digitale Informationsübertragung geeignet.

Als dimensionsstabile Träger kommen die für die Flexodruckplattenherstellung üblichen in Frage.

Beispiele geeigneter dimensionsstabiler Träger sind Platten, Folien und konische und zylindrische Röhren (sleeves) aus Metallen wie Stahl, Aluminium, Kupfer oder Nickel oder aus Kunststoffen wie Polyethylenterephthalat, Polybutylenterephthalat, Polyamid und Polycarbonat, Gewebe und Vliese, wie Glasfasergewebe sowie Verbundmaterialien aus Glasfasern und Kunststoffen.

Als dimensionsstabile Träger kommen insbesondere dimensionsstabile Trägerfolien, beispielsweise Polyethylen- oder Polyesterfolien, insbesondere Polyethylenterephthalatfolien in Frage. Diese Trägerfolien sind im allgemeinen zwischen 50 und 500 µm, vorzugsweise 75 bis 400 µm, beispielsweise ca. 125 µm dick.

Diese Trägerfolien können mit einer dünnen haftvermittelnden Schicht, beispielsweise einer 1 bis 5 µm dicken Schicht auf der der lichtempfindlichen Aufzeichnungsschicht zugewandten Seite der Trägerfolie beschichtet sein. Diese Haftschicht kann beispielsweise aus einem Gemisch aus einem Polycarbonat, einem Phenoxyharz und einem multifunktionellen Isocyanat bestehen.

Bei der durch aktinische Strahlung vernetzbaren Schicht (A) handelt es sich erfindungsgemäß um eine Schicht, die im wesentlichen aus einem Gemisch aus mindestens einem elastomeren Bindemittel, einer oder mehrerer ethylenisch ungesättigten copolymerisierbaren organischen Verbindung, einem Photoinitiator oder einem Photoinitiatorsystem sowie gegebenenfalls weiteren Hilfsstoffen besteht und nach bildmäßiger Belichtung durch einen Entwickler auswaschbar ist.

Als elastomere Bindemittel eignen sich beispielsweise elastomere polymere Bindemittel, wie z.B. Polyalkandiene, Vinylaromat/ Alkadien-Copolymerisate und -Blockpolymerisate, Alkadien/Acrylnitril-Copolymerisate, Ethylen/Propylen-Copolymerisate, Ethylen/ Propylen/Alkadien-Copolymerisate, Ethylen/Acrylsäure-Copolymerisate, Alkadien/Acrylsäure-Copolymerisate, Alkadien/Acrylat/Acrylsäure-Copolymerisate und Ethylen/(Meth)Acrylsäure/(Meth)Acrylat-Copolymerisate.

Ganz besonders gut geeignet sind Elastomere, welche konjugierte Alkadiene wie Butadien oder Isopren und Styrol einpolymerisiert enthalten.

Das elastomere Bindemittel ist in der photopolymerisierbaren Schicht (A) in einer Menge von 50 bis 95, vorzugsweise 50 bis 90 Gew.-%, bezogen auf die Gesamtmenge der in (A) enthaltenen Komponenten enthalten.

Des weiteren enthält die erfindungsgemäß zu verwendende photopolymerisierbare reliefbildende Aufzeichnungsschicht (A) übliche und bekannte copolymerisierbare ethylenisch ungesättigte organische Verbindungen, welche mit den polymeren Bindemitteln verträglich sind, in einer Menge von 1 bis 60, vorteilhafterweise von 2 bis 50, und insbesondere von 3 bis 40 Gew.-%, bezogen auf die Gesamtmenge von (A). Die Bezeichnung "verträglich" zeigt an, daß die betreffenden Monomere mit dem elastomeren Bindemittel so gut abmischbar sind, daß in der betreffenden photopolymerisierbaren reliefbildenden Aufzeichnungsschicht (A) keine Trübungen oder Schlieren hervorgerufen werden. Beispiele geeigneter Monomerer sind die üblichen und bekannten Acrylate und Methacrylate von ein- oder mehrwertigen Alkoholen, Acryl- und Methacrylamide, Vinylether und Vinylester, Allylether und Allylester sowie Fumar- oder Maleinsäurediester, insbesondere die Ester der Acryl- und/ oder Methacrylsäure mit ein- und vorzugsweise mehrwertigen Alkoholen, wie z.B. Ester der Acryl- oder Methacrylsäure mit Äthandiol, Propandiol, Butandiol, Hexandiol, Oxaalkandiolen, wie z.B. Diethylenglykol, oder Ester der Acryl- oder Methacrylsäure mit drei- oder mehrwertigen Alkoholen, wie z.B. Glycerin, Trimethylolpropan, Pentaerythrit oder Sorbit. Beispiele für besonders geeignete mono- und polyfunktionelle Acrylate oder Methacrylate sind Butylacrylat, Butylmethacrylat, 2-Ethylhexylacrylat, Lauryl(meth)acrylat, Hexandioldiacrylat, Hexandioldimethacrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, 1,1,1-Trimethylolpropantri(meth)acrylat, Di-, Tri- und Tetraethylenglykoldi(meth)acrylat, Tripropylenglykoldi(meth)acrylat oder Pentaerythrit-tetra(meth)acrylat, des weiteren Poly(ethylenoxid)di(meth)acrylat, ω-Methylpoly(ethylenoxid)-α-yl-(meth)acrylat, N,N-Diethylaminoethylacrylat, ein Umsetzungsprodukt aus 1 mol Glycerin, 1 mol Epichlorhydrin und 3 mol Acrylsäure sowie Glycidylmethacrylat und Bisphenol-A-diglycidetheracrylat.

Es eignen sich auch Gemische photopolymerisierbarer ethylenisch ungesättigter organischer Verbindungen, sowie z.B. Gemische monofunktioneller (Meth)acrylate, wie z.B. Hydroxiethylmethacrylat mit polyfunktionellen (Meth)acrylaten der oben angeführten Art.

Außer den (Meth)acrylsäureestern eignen sich auch Derivate von (Meth)acrylsäureamiden, wie z.B. N-Methylol-(meth)acrylamidether von Polyolen (z.B. Glykol).

Neben elastomerem Bindemittel und copolymerisierbaren ethylenisch ungesättigten monomeren Verbindungen enthält die durch aktinische Strahlung vernetzbare Schicht (A) (= lichtempfindliche Aufzeichnungsschicht(A)) einen oder mehrere Photoinitiatoren, wie z.B. Benzoin oder Benzoinderivate, wie Benzoinether geradkettiger oder verzweigter Monoalkohole mit 1 bis 6 Kohlenstoffatomen, z.B. Benzoinmethyl-, -ethyl-, -isopropyl-, -n-butyl-, -isobutylether, symmetrisch oder unsymmetrisch substituierte Benzilacetale, wie Benzildimethylacetal, Benzil-1-methyl-l-ethylacetal, Diarylphosphinoxide, wie z.B. 2,4,6-Trimethylbenzoyldiphenylphosphinoxid oder 2,6-Dimethoxybenzoyldiphenylphosphinoxid oder Acryldiarylphosphinoxide gemäß DE-OS 29 09 992, oder Hydroxipropanone wie 1-Phenyl-2-methyl-2-hydroxi-1-propanon und 1-Hydroxicyclohexylphenylketon. Sie können allein oder im Gemisch miteinander oder in Verbindung mit Coinitiatoren verwendet werden, z.B. Benzoinmethylether mit Triphenylphosphin, Diacylphosphinoxide mit tertiären Aminen oder Acyldiarylphosphinoxide mit Benzildimethylacetal.

In den Gemischen werden die Photoinitiatoren bzw. Photoinitiatorsysteme in einer Menge von 0,001 bis 10, vorteilhaft 0,1 bis 5 und insbesondere 0,3 bis 2 Gew.-%, bezogen auf die Gesamtmenge der lichtempfindlichen Aufzeichnungsschicht (A), verwendet, wobei die Menge mitbestimmt wird von der Mitverwendung photopolymerisierbarer Monomerer.

Als gegebenenfalls mitzuverwendende weitere Hilfsstoffe können - im allgemeinen in einer Menge von 0,001 bis 2 Gew.-%, bezogen auf die Gesamtmenge der lichtempfindlichen Aufzeichnungsschicht (A) - Inhibitoren gegen die thermische Polymerisation, die keine nennenswerte Eigenabsorption in dem aktinischen Bereich, in dem der Photoinitiator absorbiert, aufweisen, zugesetzt werden, wie z.B. 2,6-Di-tert.-butyl-p-kresol, Hydrochinon, p-Methoxiphenol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau G (C.I. 52040).

Auch geeignete Farbstoffe, Pigmente oder photochrome Zusätze können dem lichtempfindlichen Gemisch der Aufzeichnungsschicht (A) in einer Menge von 0,0001 bis 2 Gew.-%, bezogen auf die Gesamtmenge der lichtempfindlichen Aufzeichnungsschicht (A), zugesetzt werden. Sie dienen der Identifizierung oder ästhetischen Zwecken. Voraussetzung für die Auswahl und die Menge solcher Zusätze ist, daß sie ebenso wenig wie die Inhibitoren der thermisch initiierten Polymerisation die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, dem Salz bzw. Amid aus Rhodamin D (Basic Violett 10, C.I. 45170), Methylenblau B (C.I. 52015), Thioninblau G (C.I. 52025), Thioninblau G (C.I. 52025) oder Acridinorange (C.I. 46005). Diese Farbstoffe können auch zusammen mit einer hinreichenden Menge eines Reduktionsmittels verwendet werden, welches den,Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxylamins, vorzugsweise die Kalium-, Calcium- und Aluminiumsalze. Letztere können zugleich als Inhibitoren der thermisch initiierten Polymerisation dienen. Die Reduktionsmittel können im allgemeinen in Mengen von 0,005 bis 5 Gew.-%, bezogen auf das Gemisch, zugesetzt werden, wobei sich in vielen Fällen der Zusatz eines 3- bis 10fachen der Menge an mitverwendetem Farbstoff bewährt hat. Zusätzlich können die Rezepturen noch in Mengen von 1 bis 20, vorzugsweise 3 bis 10 Gew.-% Basen enthalten, die die Säurefunktionen des Ethylen-Acrylsäure-Copolymers teilweise oder vollständig neutralisieren. Gut geeignete Basen sind beispielsweise Alkalihydroxide, Alkalialkoholate, sowie Amine und Alkanolamine. Besonders gut geeignete Basen sind Monoethanolamin, Diethanolamin, Butylethanolamin und Triethanolamin.

Die Herstellung der erfindungsgemäß zu verwendenden photopolymerisierbaren reliefbildenden Aufzeichnungsschicht (A) aus ihren Bestandteilen erfolgt im allgemeinen durch Mischen der Bestandteile mit Hilfe bekannter Mischmethoden und durch Verarbeiten der Mischung zur Aufzeichnungsschicht (A) mit Hilfe bekannter Techniken, wie Gießen aus Lösung, Kalandrieren oder Extrudieren, wobei diese Maßnahmen auch in geeigneter Weise miteinander kombiniert werden können.

Die durch aktinische Strahlung vernetzbare Schicht (A) weist im allgemeinen eine Dicke von 200 bis 8000, insbesondere 500 bis 6000 µm auf. Auf dieser durch aktinische Strahlung vernetzbaren Schicht (A) ist die gegen aktinische Strahlung empfindliche Schicht (B) sowie gegebenenfalls eine abziehbare Deckfolie aufgebracht. Die Schicht (B) ist in Entwickler löslich oder dispergierbar, wobei sie erfindungsgemäß im aktinischen Bereich eine optische Dichte > 2,5 aufweist, durch einen oder mehrere Laserpulse im Wellenlängenbereich zwischen 254 und 532 nm mit einer Energie von > 5 bis zu 50 J/cm² eine Änderung der optischen Dichte von > 1 erfährt und im wesentlichen aus arylazophosphonathaltigen Verbindungen besteht.

Als erfindungsgemäß für die gegen aktinische Strahlung empfindliche Schicht (B) einzusetzenden arylazophosphonathaltigen Verbindungen eignen sich sowohl solche, die Arylazophosphonat-Gruppen in einer Polymerhauptkette (I) enthalten, als auch solche, die die Arylazophosphonat-Gruppen als Seitenkette an einer Polymerhauptkette (II) enthalten.

Als Verbindungen (I) eignen sich beispielsweise solche mit Gruppen der Formel 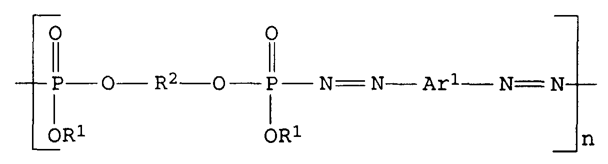 worin
- R¹ =: Alkyl mit 1 bis 12, vorzugsweise 3 bis 6 Kohlenstoffatomen
- R² =: ―(CH₂)ₙ―, ―(CH₂)ₙ―O―(CH₂)ₘ―,

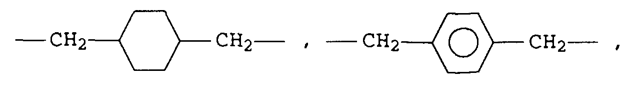

―(CH₂)₂―O―X―O―(CH₂)₂―,
- n =: 1, 2, 3 bis 10
- m =: 1, 2, 3 bis 10
- Ar¹ =: 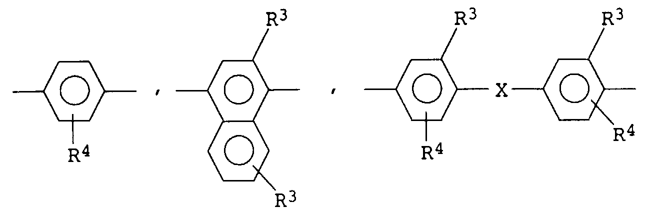
- R³, R⁴ =: ―OCH₃, OH, ―SO₃H, ―O―CH₂―CO₂H
- X =: 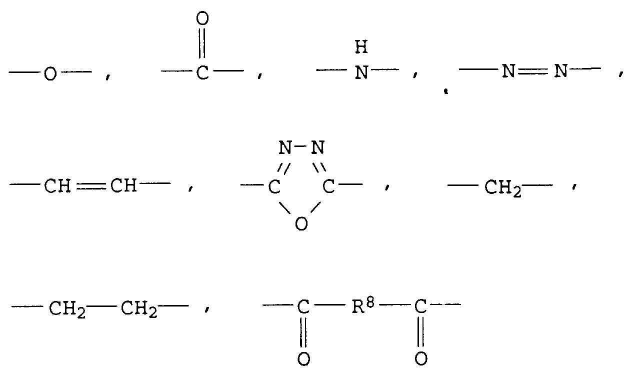
- R⁸ =: Alkandiyl mit 1 bis 12, vorzugsweise 3 bis 6 Kohlenstoffatomen, Arylen mit 6 bis 10 Kohlenstoffatomen, vorzugsweise 6 Kohlenstoffatomen.

Als Verbindungen (II) eignen sich beispielsweise solche, die an Polymerhauptketten folgende Gruppen gebunden enthalten:
a) 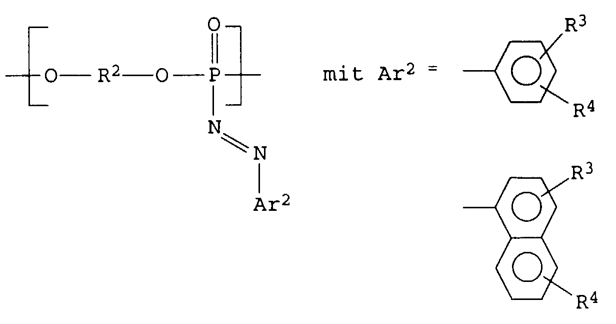
b)

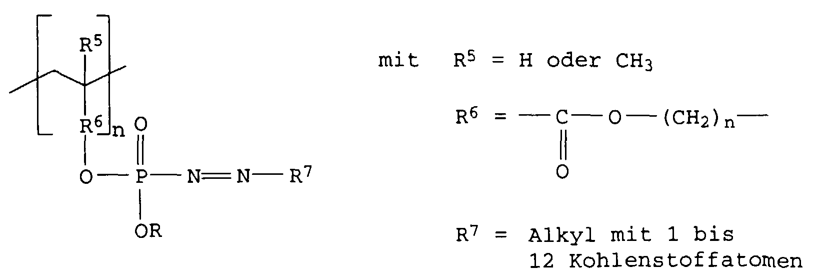

Verbindungen des Typs (I) lassen sich sehr einfach aus Bis-Phosphiten mit aromatischen Bis-Diazonium-Salzen durch Kupplung herstellen. Die Synthese geeigneter Bis-Phosphite ist von A. I. Zavalishina, et al. Zhurnal Obshchei Khimii, 38, 2271-76 (1968) beschrieben. Die Herstellung geeigneter aromatischer Bis-Diazonium-Salze erfolgt nach Standardvorschriften. Die Kupplungsreaktion dieser beiden Reaktanden geschieht durch einfaches Zusammenbringen der entsprechenden Lösungen.

Verbindungen des Typs (IIa) lassen sich durch Umsetzung von Polyphosphiten, die durch Umesterung von Dialkylphosphiten mit den entsprechenden Diolen zugänglich sind, mit aromatischen Diazonium-Salzen herstellen. Die Synthese der Polyphosphite ist beschrieben bei: S. Penczek, J. Pretula, Macromolecules 26, 2228 (1993); J. Pretula, S. Penczek, Macromol. Chem. Phys. 191, 671 (1990). Eine andere Methode zur Herstellung von Polyphosphiten beruht auf der ringöffnenden Polymerisation von cyclischen Phosphiten wie z.B.

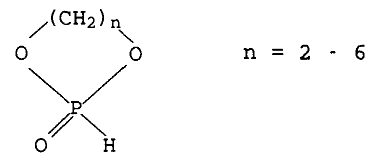

Es kann auch noch eine für aktinisches Licht transparente abziehbare Folie, eine Deckfolie, die eine Dicke von 5 bis 300 µm, die beispielsweise aus Polyethylen oder Polyethylenterephthalat besteht, auf der Schicht (B) angebracht sein.

Die Verarbeitungsschritte, die die Belichtung mit aktinischem Licht, Entwickeln und Trocknen umfassen , sind ausführlich z.B. in der nyloflex®-Arbeitsanleitung (IIR 340705/1185) der BASF Aktiengesellschaft beschrieben.

Dei ebenfalls gegen aktinsiche Strahlung empfindliche Schicht (B) läßt sich mit einem UV-Laser, vorzugsweise mit einem gepulsten XeCl-Eximerlaser (Wellenlänge: 308 nm), bildmäßig beschreiben. Entsprechende Laser werden z.B. von der Fa. Lambda Physics angeboten. Die bildmäßige Beschreibung kann zweckmäßigerweise auf einer Trommel erfolgen, auf der die Platte montiert ist. Hierbei wird die Schicht (B) an den Stellen, die mit dieser aktinischen Strahlung beaufschlagt werden, ablatiert. Auf diese Weise wird für den nachfolgenden vollflächigen Belichtungsvorgang eine Maske, bestehend aus un- und durchlässigen Bildteilen, erzeugt. Die Schicht (B) zeichnet sich dabei dadurch aus, das sie nur mit hohen Energie-Werten von >5 bis zu 50 J/cm² ablatierbar ist; andernfalls würde sie sonst bei der vollflächigen Belichtung mit aktinischem Licht ablatiert. Nach der digitalen Informationsübertragung erfolgt die vollflächige Belichtung mit aktinischem Licht. Dies kann entweder auf der Trommel des UV-Lasers geschehen, oder man demontiert die Platte und führt die vollflächige Belichtung in einem konventionellen Flachbelichter (z.B. FIII-Belichter der Fa. BASF) durch. Anschließend wird das Aufzeichnungselement entwickelt. Dazu kann man handelsübliche Durchlauf- oder Rundwascher benutzen, wie sie z.B. von Fa. BASF angeboten werden. Entsprechend der Chemie der Schicht (B) muß diese gegebenenfalls in einem Vorentwickler entfernt werden, wenn diese Schicht in dem Entwickler der Schicht (A) nicht löslich oder dispergierbar ist. Der Vorentwicklungsschritt kann sehr einfach, beispielsweise in handelsüblichen Plüschwaschern der Firma BASF durchgeführt werden, die hierfür hervorragend geeignet sind.

Als geeignete Entwickler für Schicht (A) können Gemische aus Perchlorethylen mit Alkoholen, Gemische aus Kohlenwasserstoffen mit Alkoholen, Gemische von Alkohol mit Wasser, reines Wasser oder auch Gemische aus Wasser und darin löslichen Bestandteilen, wie z.B. Soda, Natronlauge, Zitronensäure, Milchsäure, Tenside, usw., benutzt werden.

Nach dem Entwickeln wird das Aufzeichnungsmaterial noch einem Trocknungsschritt unterworfen. Hierbei wird der noch in der Reliefschicht enthaltene Entwickler entfernt. Auch hier sind alle handelsüblichen Trockner, wie z.B. auch die der BASF AG, geeignet.

Die Beispiele zeigen die Herstellung der erfindungsgemäßen lichtempfindlichen Aufzeichnungselemente sowie die mit diesen Aufzeichnungselementen erzielten Druckergebnisse.

Die in den Beispielen genannten Teile und Prozente sind, soweit nicht anders angegeben, Gewichtsteile und Gewichtsprozente.

### Vergleichsbeispiel 1:

Entsprechend Beispiel 2 der US-A-5 262 275 wurde eine lichtempfindliche Aufzeichnungsschicht gefertigt. Dieses lichtempfindliche Aufzeichnungsmaterial wurde auf eine Vakuumtrommel montiert und mittels eines Nd:YAG-Lasers (Wellenlänge 1064 nm) belichtet. Der Spotdurchmesser des IR-Laserstrahls war auf 10 µm eingestellt. Es handelte sich hierbei um einen Belichter der Fa. Basel-Scheel. Anschließend wurde die Platte von der Trommel demontiert und in einem FIII-Belichter (von BASF) 15 Minuten lang vollflächig belichtet. Danach wurde die Platte in einem BASF-Rundwascher mit einem 3:1-Gemisch aus Perchlorethylen/Butanol entwickelt und anschließend 2 h bei 60°C getrocknet. Das gewählte Druckmotiv wies eine Rasterweite von 54 L/cm auf und hatte einen Tonwertumfang von 3-95°C. Dann wurde diese Flexodruckplatte auf einer handelsüblichen Flexodruckmaschine montiert, und es wurde Polyethylen-Folie mit Alkoholfarben bedruckt. Anschließend wurde das Druckergebnis im Vergleich zu Beispiel 1 visuell bewertet.

### Beispiel 1:

Eine Lösung, bestehend aus 10 Teilen Arylazophosphonat I der Formel (I)
(mit R¹ = CH₃; R² = 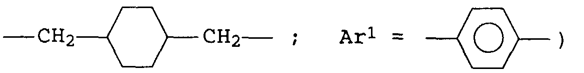 und 90 Teilen Methylenchlorid, wurde auf eine Polyethylenterephthalatfolie (125 µm Mylar der Fa. DuPont) gegossen und zwar derart, daß die optische Dichte dieser Schicht bei > 3 liegt.

Dieser Verbund wurde auf eine Cyrel® 107 PLS+-Druckplatte (von Fa. DuPont) aufkaschiert, nachdem man bei der Platte die Schutzfolie und die darunterliegende Deckschicht durch Abziehen entfernt hatte.

Nach Abziehen der Schutzfolie wurde dieses lichtempfindliche Aufzeichnungsmaterial auf eine Vakuumtrommel montiert und mittels eines XeCl-Lasers (Wellenlänge 308 nm) belichtet. Der Spotdurchmesser des UV-Laserstrahls war auf 5 µm eingestellt. Es handelte sich hierbei um einen Laser der Fa. Lambda-Physics. Anschließend wurde die Platte von der Trommel demontiert und in einem FIII-Belichter (von BASF) 15 Minunten lang vollflächig belichtet. Danach wurde die Platte in einem BASF-Rundwascher mit einem 3:1-Gemisch aus Perchlorethylen/Butanol entwickelt und anschließend 2 h bei 60°C getrocknet. Das gewählte Druckmotiv entsprach dem vom Vergleichsbeispiel 1. Dann wurde diese Flexodruckplatte auf einer handelsüblichen Flexodruckmaschine montiert, und es wurde PE-Folie mit Alkoholfarben bedruckt. Anschließend wurde das Druckergebnis visuell bewertet, Der direkte Vergleich mit Vergleichsbeispiel I machte eindrucksvoll deutlich, das die Rasterverläufe bei dem Beispiel 1 mindestens genauso gut sind wie bei Vergleichsbeispiel 1.

## Patentansprüche

1. Zur Herstellung von Flexodruckplatten durch digitale Informationsübertragung geeignetes mehrschichtiges Aufzeichnungselement, das auf einem dimensionsstabilen Träger übereinander angeordnet eine, gegebenenfalls mit dem dimensionsstabilen Träger durch eine Haftschicht verbundene, durch aktinische Strahlung vernetzbare Schicht (A), eine ebenfalls gegen aktinische Strahlung empfindliche Schicht (B) sowie gegebenenfalls eine abziehbare Deckfolie aufweist, dadurch gekennzeichnet, daß die durch aktinische Strahlung vernetzbare Schicht (A) durch bildmäßige Belichtung mit aktinischer Strahlung von 0,5 bis 5 J/cm² vernetzt wird und danach durch Entwickler auswaschbar ist und im wesentlichen aus einem Gemisch aus mindestens einem elastomeren Bindemittel, ethylenisch ungesättigten copolymerisierbaren organischen Verbindungen, einem Photoinitiator oder Photoinitiatorsystem sowie gegebenenfalls weiteren Hilfsstoffen besteht, und die auch gegen aktinische Strahlung empfindliche Schicht (B) eine in Entwickler lösliche oder dispergierbare Schicht ist, die im aktinischen Bereich eine optische Dichte > 2,5 aufweist, durch einen oder mehrere Laserpulse im Wellenlängenbereich zwischen 254 und 532 nm mit einer Energie von > 5 bis zu 50 J/cm² eine Änderung der optischen Dichte von > 1 erfährt und im wesentlichen aus arylazophosphonathaltigen Verbindungen besteht.

2. Aufzeichnungselement nach Anspruch 1, dadurch gekennzeichnet, daß sowohl für die Schicht (A) als auch für die Schicht (B) Wasser oder Alkohol/Wasser-Gemische als Entwickler geeignet sind.

3. Aufzeichnungselement nach Anspruch 1, dadurch gekennzeichnet, daß sowohl für Schicht (A) als auch für Schicht (B) ein organisches Lösungsmittel oder Lösungsmittelgemisch als Entwickler geeignet sind.

4. Aufzeichnungselement nach Anspruch 1, dadurch gekennzeichnet, daß für Schicht (A) ein organisches Lösungsmittel oder Lösungsmittelgemisch und für Schicht (B) Wasser oder ein Alkohol/Wasser-Gemisch als Entwickler geeignet ist.

5. Verfahren zur Herstellung von Flexodruckplatten, dadurch gekennzeichnet, daß mit einem UV-Laser die gegen aktinische Strahlung empfindliche Schicht (B) des mehrschichtigen Aufzeichnungselementes gemäß Anspruch 1 aus einem digitalen Datenbestand bildmäßig strukturiert wird, anschließend die Schicht (A) durch vollflächige Belichtung mit aktinischer Strahlung in den später druckenden Bereichen vernetzt wird, und danach die Schicht (B) in einem Entwickler dispergiert oder gelöst wird und in demselben oder einem anderen Entwickler die nicht vernetzten Bildteile der Schicht (A) entwickelt werden.

## Claims

1. A multilayer recording element which is suitable for producing flexographic printing plates by digital information transfer and has, arranged one on top of the other on a dimensionally stable substrate, a layer (A) which is crosslinkable by actinic radiation and, if required, is bonded to the dimensionally stable substrate by an adhesion-promoting layer, a layer (B) which is likewise sensitive to actinic radiation and, if required, a peelable cover sheet, wherein the layer (A) crosslinkable by actinic radiation is crosslinked by imagewise exposure to actinic radiation of from 0.5 to 5 J/cm² and can then be washed out by a developer and essentially comprises a mixture of at least one elastomeric binder, ethylenically unsaturated copolymerizable organic compounds, a photoinitiator or photoinitiator system and, if required, further assistants, and the layer (B), which is also sensitive to actinic radiation, is a layer which is soluble or dispersible in developers and has an optical density > 2.5 in the actinic range, undergoes a change in the optical density by > 1 as a result of one or more laser pulses in the wavelength range from 254 to 532 nm with an energy of from > 5 to 50 J/cm² and essentially comprises arylazophosphonate-containing compounds.

2. A recording element as claimed in claim 1, wherein water or an alcohol/water mixture is suitable as the developer both for the layer (A) and for the layer (B).

3. A recording element as claimed in claim 1, wherein an organic solvent or solvent mixture is suitable as the developer both for layer (A) and for layer (B).

4. A recording element as claimed in claim 1, wherein an organic solvent or solvent mixture is suitable as the developer for layer (A) and water or an alcohol/water mixture is suitable as the developer for layer (B).

5. A process for producing flexographic printing plates, wherein the layer (B) of the multilayer recording element as claimed in claim 1, which layer is sensitive to actinic radiation, is structured imagewise from a digital data set by means of a UV laser, the layer (A) is then crosslinked by uniform exposure to actinic radiation in the subsequently printing parts and the layer (B) is then dispersed or dissolved in a developer and the noncrosslinked image sections of the layer (A) are developed in the same or a different developer.

## Revendications

1. Elément d'enregistrement à plusieurs couches convenant à la préparation de plaques d'impression flexographiques par transfert numérique de données, comportant, en disposition successive sur un support à dimensions stables, une couche A réticulable par les rayonnements actiniques, éventuellement liée au support à dimensions stables par une couche d'adhérence, une couche B également sensible aux rayonnements actiniques et le cas échéant une feuille de couverture détachable, caractérisé par le fait que la couche A réticulable par les rayonnements actiniques est réticulée par exposition avec formation d'image à des rayonnements actiniques de 0,5 à 5 J/cm² et est ensuite apte au lavage par un révélateur, et consiste essentiellement en un mélange d'au moins un liant élastomère, des composés organiques à insaturation éthylénique copolymérisables, un photo-inducteur ou un système photo-inducteur et le cas échéant d'autres produits auxiliaires, et la couche B, également sensible aux rayonnements actiniques, est une couche soluble ou dispersable dans le révélateur, qui présente dans le domaine actinique une densité optique supérieure à 2,5, subit une modification de la densité optique supérieure à 1 par une ou plusieurs impulsions lasers dans le domaine des longueurs d'ondes de 254 à 532 nm avec une énergie supérieure à 5 et pouvant aller jusqu'à 50 J/cm², et consiste essentiellement en composés contenant des arylazophosphonates.

2. Elément d'enregistrement selon la revendication 1, caractérisé par le fait que les révélateurs qui conviennent aussi bien pour la couche A que pour la couche B sont l'eau ou des mélanges alcool/eau.

3. Elément d'enregistrement selon la revendication 1, caractérisé par le fait que les révélateurs qui conviennent aussi bien pour la couche A que pour la couche B consistent en solvants organiques ou mélanges de solvants organiques.

4. Elément d'enregistrement selon la revendication 1, caractérisé par le fait que le révélateur approprié pour la couche A est un solvant organique ou mélange de solvants organiques et, pour la couche B, l'eau ou un mélange alcool/eau.

5. Procédé pour la préparation de plaques d'impression flexographique, caractérisé par le fait que l'on structure en forme d'image, à l'aide d'un laser UV, la couche B de l'élément d'enregistrement à plusieurs couches de la revendication 1, sensible aux rayonnements actiniques, à partir d'une banque de données numériques, on réticule ensuite la couche A par éclairement sur toute la surface à l'aide de rayonnements actiniques dans les intervalles ultérieurement imprimeurs puis on disperse ou en dissout la couche B dans un révélateur et on développe les parties d'image non réticulée de la couche A dans le même révélateur ou dans un autre révélateur.
